Europäisches Patentamt

European Patent Office

Office européen des brevets

(19)

(11) Publication number: **0 335 589**
**A2**

(12) # EUROPEAN PATENT APPLICATION

(21) Application number: **89302901.7**

(22) Date of filing: **23.03.89**

(51) Int. Cl.4: **H01L 23/36**

(30) Priority: **28.03.88 GB 8807449**

(43) Date of publication of application:
**04.10.89 Bulletin 89/40**

(84) Designated Contracting States:
**AT BE CH DE ES FR GB GR IT LI LU NL SE**

(71) Applicant: SEMIKRON LIMITED
4 Marshgate Drive
Hertford Hertfordshire SG13 7BQ(GB)

(72) Inventor: Bentley, Paul
Dawill Lower Road Little Hallingbury
Bishops Stortford Hertfordshire,CM22
7AR(GB)

(74) Representative: Russell-Rayner, Albert Patrick
Business Centre Avenue One Business Park
Letchworth Garden City Hertfordshire SG6
2HB(GB)

(54) Device for cooling electrical and electronic equipment.

(57) A cooling device for electric and/or electronic components, the device being characterised by a main body (31 )for providing a component support or mounting surface (32) affording good thermal contact and heat transfer between the main body and the component mounted thereupon, the main body having owtwardly extending arms provided with heat transfer surfaces (35,) which together with further sets of heat exchange surfaces (39) connecting with the main body, project outwardly from the arms and the main body in such direction and manner that they do not limit the size of a component mounted to the support or mounting surface.

Fig. 3.

EP 0 335 589 A2

## DEVICE FOR COOLING ELECTRICAL ELECTRONIC EQUIPMENT

This invention relates to a device arrangements for cooling electrical and/or electronic equipment.

It is well known that when in use many electrical and/or electronic circuits generate significant amounts of heat energy. Often, in practice, the amount or magnitude of the heat energy generated by a component can be sufficient physically to damage and/or at least adversely affect the operating characteristics of the component itself and/or other adjacent components in the circuit within a relatively short time interval from the commencement of operation.

It is also well known that the heat generated by a component whilst not necessarily adversely affecting its own performance parameters and operational characteristics may well adversely affect the performance parameters of and operational characteristics of other compnents in the proximity thereof.

In practice, components involved in the rectification of large value currents, and electronic devices intended for the switching of relatively large currents are frequently prone to the creation of excessive levels of heat energy.

In particular, the present invention is concerned with the cooling of components commonly called power semiconductors.

Power semiconductors are used for many purposes and commonly in the rectification and switching of relatively large value currents. Such switching operations often lead to the production of correspondingly high levels of heat energy whereby, in so far as commonly used electronic equipment is involved, it is a frequent requirement that high wattage levels of the heat energy need to be efficiently dissipated.

It is a common practice to reduce the effects of such excessive heat energy production by mounting the component involved upon a relatively large volume/mass of a highly thermally conductive material which is so shaped as to facilitate the transfer of heat away from the component and dissipate the heat into the ambient surroundings.

Such elements are commonly called Heatsinks.

Generally speaking a Heatsink comprises a structure formed from a material which has high thermal conductivity and which incorporates a relatively massive main body portion against which a component to be cooled is mounted or positioned in very close proximity, and an arrangement of fins projecting from the body and serving to produce a relatively large heat exchange surface area to carry heat energy outwardly from the main body.

A common material for use as a Heatsink is Aluminium since this combines a high thermal conductivity with various other qualities and characteristics which have through experience been found to be useful in the formation of Heatsinks.

According to the invention there is provided a cooling device characterised by a main body for providing a component support or mounting surface affording good thermal contact and heat transfer between the main body and the component mounted thereupon, and a plurality of heat exchange surfaces projecting outwardly from the main body in such direction and manner that they do not limit the size of a component mounted to the support or mounting surface.

Preferably, the main body is bounded by two generally parallel planes containing the upper and lower surfaces of the main body. This feature has been found to make it easily possible to mount components to be cooled having a wide range of shapes and sizes.

Preferably, the heat exchange surfaces comprise fins whose planes are transverse to the plane of the support or mounting surface.

For a better understanding of the invention and to show how to carry the same into effect reference will be made to the accompanying drawings in which:-

Figures 1 and 2 are end views of known constructions for Heatsinks;

Figure 3 is an elevation of a Heatsink incorporating the features of the present invention; and;

Figure 4 is an end view of Figure 1.

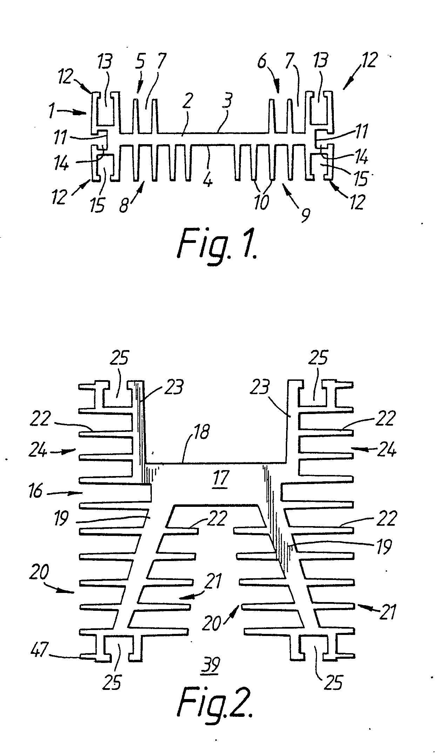

Referring now to Figure 1 the Figure illustrates a Heatsink 1 having a main body section 2 presenting upper and lower mounting or support surfaces 3 and 4 for components to be cooled. Two groups 5 and 6 of fins 7 extend in side by side parallel arrangement perpendicularly from the upper surface 3, and two further groups 8 and 9 of fins 10 extend in side by side parallel arrangement perpendicularly from the lower surface 4.

The Heatsink as so far discussed is of elongate form, the Figure 1 being effectively an end view of the Heatsink whereby the faces 11, in practice, provide the side walls of the Heatsink. Along these longer edges 11 the main body section 2 there are respectively provided multi-slot arrangements 12. The multi-slot arrangements 12 respectively comprise three slots 13,14 and 15. In each case the slots 13 and 15 face away from each other and the slot 14 effectively faces in a direction at right angles to the other two slots.

The various slots 13,14, and 15 are part of the arrangements provided for mounting the Heatsink from a support panel, chassis or the like (not shown) and are thus shaped as to provide location and guide slots for the heads of mounting bolts. With this arrangement the Heatsink can be lengthwise selectively positioned relative to the bolts whose heads engage with the slots.

By providing the slots 13,14 and 15 opening in the different directions a selection of mounting positions for the Heatsink is made available.

The electrical/electronic elements that are required to be cooled by the Heatsink are intended to be mounted to the upper and/or lower surfaces 3,4 and for this reason the upper and lower surfaces 3,4 will be provided with one or more threaded bores (not shown) for receiving component mounting bolts screws or the like.

It will be observed that the fins effectively shroud and define the overall width or space available for the component to be mounted. Thus, in the case of cylindrical components the positioning of the fins sets the maximum component dimensions, at least in one direction, that can be accommodated upon the Heatsink mounting surface.

Referring now to Figure 2 this shows a second known form of Heatsink 16 having a main body 17 presenting an upwardly facing main surface 18. The Heatsink has two downwardly and outwardly diverging main 'legs' 19. Groups 20 and 21 of spaced apart fins 22 project from the legs 19. The fins 22 are aligned parallel to the surface of 18 of the main body. Two further slightly outwardly diverging 'legs' 23 project upwardly from the main body. The 'legs' 23 are each provided with a groups 24 of fins 22. All of the fins of the groups 24 are parallel to the previously mentioned fins 22. A bolt head locating slot arrangement 25 is provided at the end region of each of the 'legs' 19 and 23. The slot arrangements are symmetrically positioned relative to the main surface.

The above discussed Heatsink is used and mounted as discussed in relation to Figure 1. It will be noted for each of the above mentioned known Heatsink constructions that the provision of the legs and fins extending lengthwise of the component mounting surface imposes undesirable constraints on the size and form of components that can be mounted upon the Heatsink.

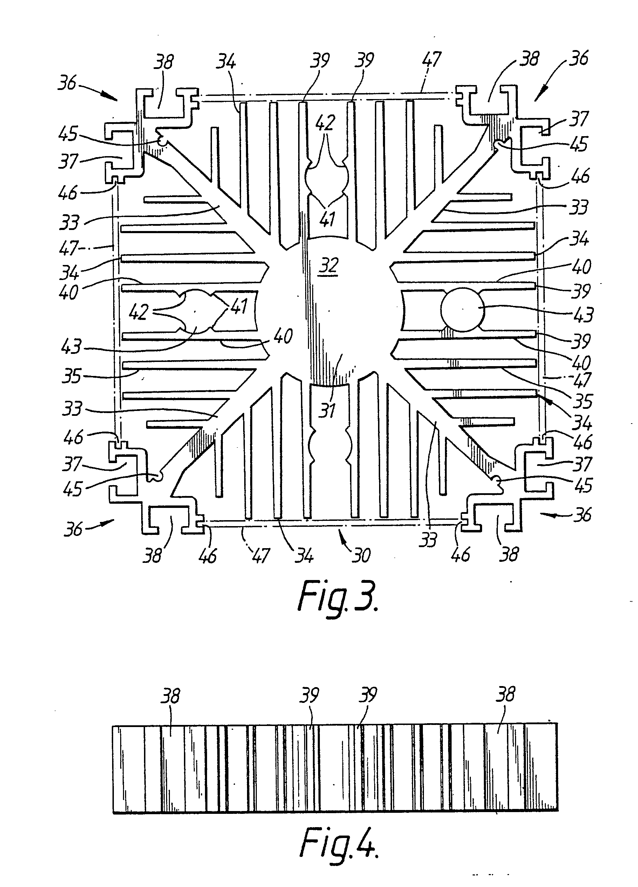

Referring now to Figures 3 and 4, these Figures illustrate a Heatsink 30 in accordance with the invention. The Heatsink shown therein comprises in the embodiment shown a cylindrical main body 31 having upper and lower circular mounting or support surfaces 32 for components to be cooled. It is to noted that the main body could have other shapes, i,e, rectangular, triangular, hexagonal etc.

In the Figure 3 only one of the component mounting or support surfaces is shown. Four main arms 33 radiate or extend outwards from the main body 32. With the Heatsink oriented as shown in the Figure 3 these arms 33 are directed at 45 degrees to the horizontal and vertical directions.

Each such main arm 33 is provided with two groups 34 of fins 35 the fins of each such group being arranged at 45 degrees to the associated main arm and correspondingly spaced along the length of the associated arm.

The lengths of the fins 35 along each arm other than the outermost pair of fins on each arm are such that the ends of the fins form the sides of a square so that the Heatsink is essentially square shaped.

The end of each arm 34 terminates in a multislot arrangement 36 including two slots 37,38 facing at right angles to each other. With this arrangement the Heatsink is provided with a plurality of possible mounting positions whereby any pair of similarly facing slots 37 or 38 can be utilised for receiving studs or the like (not shown) connecting the Heatsink to a support (not shown).

In addition to the fins 35 projecting from the arms 34 there are four sets of fins 39 each comprising two fins 40 projecting directly from the main body 31. These particular fins in acccordance with an aspect of the invention, provide, in addition to their heat transfer functions, the Heatsink of Figure 3 with an additional mounting capability in that the fins 40 of each set 39 are adapted to define a stud or mounting bolt location facility or means for facilitating the securing of connections to the components mounted upon the Heatsink.

Each of the two fins 40 of each set of fins is provided with a thicker part 41 projecting towards and aligning with the corresponding part provided on the other fin 40 of the same set 39. The outer surface 42 of each such part 41 that faces the corresponding part of the adjacent fin is profiled as to define a part cylindrically shaped wall. The curvature of the surfaces 42 is such that they effectively combine to provide a cylindrical bore 43 for receiving a mounting stud or bolt or conductor connection stud or bolt. One such bolt is indicated at 44 in the Figure. In other words the Heatsink of the invention affords a mounting facility which enables two or more Heatsinks to be mounted one above the other or face to face relative to a panel, an apparatus wall or a chassis by bolts 44 engaging in the bores 43. The separation between the adjacent Heatsinks or mounting wall, panel or chassis can be selectively set by any convenient means, i.e., spacers, locking nuts or the like.

In accordance with a feature of the invention and with a view to facilitating the mounting of a cooling air circulating fan (not shown to the Heatsink, each arm 33 is provided with a bore 45 for receiving holding down bolts (not shown) for the fan. In use the fan would drive air through the spaces between the various fins 34,35 and 39 in a direction of one surface 32 to the other so that there would be a forced air flow cooling of the Heatsink.

With a view to improving the air flows through the fins it is proposed according to a further feature of the invention to provide each arm 33 of the Heatsink with a facility for mounting panels which serve effectively to box-in the end regions of the fins thereby to constrain air flow whether convective or forced to flow paths between adjacent pairs of fins.

For this purpose a relatively small slot 46 is provided in each of the facing walls of the pairs of slots 37 and 38, such that facing pairs of the slots 46 are in line with each other and open towards each other. With this arrangement a panel 47 (shown in dotted lines) can be engaged in each pair of slots 46 so that by inserting four panels 47 into the slots 46 the end regions of the fins 34,35 and 39 are effectively boxed-in. This arrangement of the panels and fins has been found to improve the flow of cooling air through the fins whether solely convection and/or forced.

Thus it will be noted that the form of Heatsink proposed by the present invention represents a significant departure from the known arrangements in that the arrangement of the fins with respect to the main body is such that the dimensions of the components to be mounted upon the Heatsink are not limited, as is the case with the known arrangements, by the fact that the fins, effectively define a boundary wall surrounding at least two sides of the main body.

In other words the present invention provides a concept for a form of Heatsink structure which is bounded by two generally parallel planes containing the upper and lower surfaces of the main body. This feature has been found to make it easily possible to mount components to be cooled having a wide range of shapes and sizes.

It will be apparent from the Figures 3 and 4 that the Heatsink of the invention is totally symmetrical in construction thereby avoiding any user or application constraints similar to those likely to arise from the provision of non-symmetrical Heatsink constructions.

This further advantage of the Heatsink construction of the present invention stems from the symmetry of the Heatsink construction in that with such symmetry the range of application is not constrained as is the situation with Heatsinks having an asymmetrical overall shape as is exemplfied by the known arrangements.

## Claims

1. A cooling device for electric and/or electronic components, the device being characterised by a main body for providing a component support or mounting surface affording good thermal contact and heat transfer between the main body and the component mounted thereupon, and a plurality of heat exchange surfaces projecting outwardly from the main body in such direction and manner that they do not limit the size of a component mounted to the support or mounting surface.

2. A cooling device as claimed in claim 1, and characterised in that the main body is bounded by two generally parallel planes containing the upper and lower surfaces of the main body.

3. A cooling device as claimed in claim 1, or 2, and characterised in that the main body provides first and second component receiving surfaces, the surfaces being located on opposite sides of the body.

4. A cooling device as claimed in claim 3, and characterised in that the shape and size of the first and second component receiving surfaces are similar to each other.

5. A cooling device as claimed in claim 1, 2, 3 or 4, and characterised in that the heat exchange surfaces comprise fins whose planes are transverse to the plane of the support or mounting surface.

6. A cooling device as claimed in claim 5, and characterised in that the heat transfer fins or the like surfaces are carried by arms outwardly directed from the main body.

7. A cooling device as claimed in claim 6, and characterised in that at least one slot is provided in each said arm the slots being so located in the arms as to provide between an adjacent pair of arms slots which are in line with each other and which open towards each other, and in that the facing slots are each adapted to receive a panel in such manner that each such the panel effectively boxes-in the free ends of the fins located between the associated arms.

8. A cooling device as claimed in claim 6, or 7, and characterised in that the free end of each arm terminates in a multi-slot arrangement including two slots opening in directions at right angles to each other, the arrangement being such that any pair of similarly facing slots can be utilised for receiving studs or the like for connecting the device to a support and/or mounting connection conductors for a component mounted upon the device, whereby the device can be mounted in a plurality of possible mounting positions.

9. A cooling device as claimed in any of claims 6, 7 or 8, and characterised in that in addition to the fins projecting from the arms there are four further sets of fins each comprising two fins projecting directly from the main body, the arrangement being such that these further sets of fins provide, in addition to their heat transfer functions, additional mounting capabilities for the device in that the fins of each further set are adapted to define a stud or mounting bolt location facility.

10. A cooling device as claimed in claim in any of claims 1 to 9, and characterised in that device is symmetrical in construction .

11. A cooling device as claimed in any of the proceding claims 6 to 10. and characterised in that each arm is provided with a bore for receiving holding down bolts or the like for the mounting a cooling air circulating fan, the arrangement being such that in use the fan would drive air through the spaces between the various fins in a direction from one main body surface to the other so that as to produce a forced air flow through the spaces between the fins of the device.

Fig. 1.

Fig.2.

Fig.3.

Fig.4.